# EUROPÄISCHE PATENTSCHRIFT

(11) **EP 0 589 316 B1**
(45) Veröffentlichungstag und Bekanntmachung des Hinweises auf die Patenterteilung: **31.01.1996**
(21) Anmeldenummer: 93114626.0
(22) Anmeldetag: 11.09.1993
(51) Int. Cl.: H05K 7/14

(54) **Baugruppenträger**
Electronic rack
Rack électronique

(30) Priorität: 19.09.1992 DE 9212653 U
(43) Veröffentlichungstag der Anmeldung: 30.03.1994
(73) Patentinhaber: Alcatel SEL Aktiengesellschaft, D-70435 Stuttgart (DE)
(72) Erfinder: Hüeber, Fritz, D-71665 Vaihingen/Enz (DE)
(74) Vertreter: Knecht, Ulrich Karl

(56) Entgegenhaltungen:
- EP-A- 0 469 185
- US-A- 3 863 113
- US-A- 4 324 330

## Beschreibung

Die Erfindung betrifft einen Baugruppenträger nach dem Oberbegriff des Anspruchs 1.

Derartige Baugruppenträger sind beispielsweise in US-A-4324330 und in dem Artikel "System 12 Bauweise" in der Zeitschrift Elektrisches Nachrichtenwesen, Band 56, Nr. 2/3, 1981, Seiten 283 bis 292 beschrieben. Zwischen den vertikalen Seitenholmen eines Gestellrahmens sind die Baugruppenträger oder -rahmen übereinander montiert, die zur Aufnahme steckbarer Baugruppen dienen und deshalb jeweils oben und unten mit Führungsschienen sowie rückseitig mit einer Verdrahtungsrückwand und Steckkontaktleisten ausgerüstet sind. Die beiden rechteckigen Seitenwände der Baugruppenträger sind jeweils aus Blech und in den Ecken durch vier Schienen oder Querträger miteinander verbunden. Diese horizontalen Querträger sind Profilschienen, in die Lochstreifen einschiebbar sind, so daß zum Beispiel die Verdrahtungsrückwände mit Schrauben befestigt werden können. Seitenwände und Querträger bestehen aus Aluminium, die Führungsschienen aus Edelstahl. Letztere sind zu Matten zusammengefaßt.

Die Seitenteile sind aus Blech geschnitten und gebogen, die Querträger aus Strangpreßprofilen zugeschnitten. Der Zusammenbau des Baugruppenträgers erfordert Montageaufwand, der kostenmäßig zu Buch schlägt.

Der Erfindung liegt die Aufgabe zugrunde, die Konstruktion so zu verbessern, daß die Fertigungskosten gesenkt werden. Gelöst wird diese Aufgabe durch die im Anspruch 1 angegebenen Merkmale. Weiterbildungen sind den Unteransprüchen zu entnehmen. Die Vorteile der erfindungsgemäßen Konstruktion sind in der folgenden Beschreibung erwähnt.

Die Erfindung wird anhand eines Ausführungsbeispiels beschrieben, das in der zugehörigen Zeichnung dargestellt ist. Darin zeigen:
Fig. 1 einen Baugruppenträger in perspektivischer Ansicht, und
Fig. 2 die rechte Seite des Baugruppenträgers nach Fig. 1 in vergrößerter Darstellung.

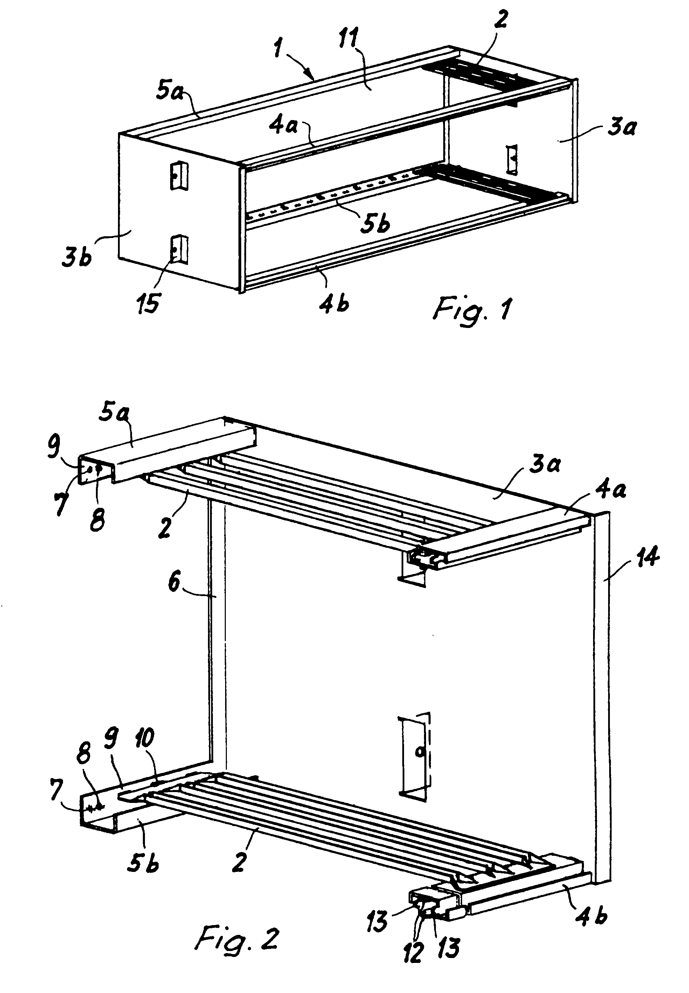

Der in den Fig. 1 und 2 gezeigte Baugruppenträger 1 dient zur Aufnahme einschiebbarer Baugruppen (nicht dargestellt) der Nachrichtentechnik und ist zum Einsetzen in Gestelle oder Schränke geeignet. Derartige Baugruppenträger sind in der Nachrichtentechnik weit verbreitet. Die einschiebbaren Baugruppen werden von Leiterplatten mit oder ohne Gehäuse gebildet und enthalten elektronische Schaltungen und deren Bauelemente, z.B. für die Vermittlungs- oder Datentechnik. Für ihre Führung und Halterung sind in den Baugruppenträgern 1 Führungsschienen 2 vorgesehen, die einzeln oder zu mehreren zu Matten zusammengefaßt oben und unten im Baugruppenträger angebracht sind. Letzterer besteht im wesentlichen aus einer linken und einer rechten Seitenwand 3a und 3b, die an den vier Ecken jeweils durch einen Querträger 4a bzw. 4b (vorn) oder 5a bzw. 5b (hinten) verbunden sind. Jeweils am oberen vorderen und hinteren Querträger 4a und 5a bzw. am unteren vorderen und hinteren Querträger 4b und 5b sind die Führungsschienen 2 befestigt.

Wesentlich an dem Baugruppenträger 1 ist, daß die Seitenwände 3a und 3b mit den hinteren Querträgern 5a und 5b einstückig aus nichtrostendem, ferritischem Stahlblech gefertigt sind. Die Querträger 5a, 5b haben U-förmig gebogenes Profil, wobei die offenen Seiten einander zugewandt sind. An der Hinterkante der Seitenwände 3a bzw. 3b steht jeweils ein relativ schmaler Streifen 6 rechtwinklig nach innen. Die beiden Streifen 6 bilden zusammen mit den außen liegenden Schenkeln 9 der hinteren Querträger 5a und 5b einen zusammenhängenden, umlaufenden Rahmen an der Rückseite des Baugruppenträgers 1. Dieser Rahmen stellt nicht nur eine gute Versteifung sondern auch die Befestigungsebene für eine Rückwand 11 sowie eine Masseschiene für Erdungs- und EMV-Maßnahmen dar. Die Rückwand 11 kann aus einer großen oder mehreren kleinen Platten mit oder ohne Verdrahtung (Leiterbahnen) bestehen. Für deren Befestigung sind in den außen liegenden Schenkeln 9 der hinteren Querträger 5a und 5b in einem Rastermaß Noppen 7 und Gewindelöcher 8 angebracht. Außerdem enthalten diese Schenkel auch Positionierschlitze 10 zum Einstecken und Fixieren der hinteren Enden der Führungsschienen oder -matten 2. In den Fig. 1 und 2 sind jeweils nur eine obere und eine untere Führungsschienenmatte 2 mit je drei Führungsschienen eingezeichnet.

Jede Führungsschiene 2 hat eine dreistufige Nutbreite. Und zwar ist die Führungsschiene 2 am vorderen Ende im Anschluß an die Einführungsschrägen auf einer relativ kurzen Länge von beispielsweise 10 mm geringfügig breiter als die Leiterplatte der vorgesehenen Baugruppe dick ist. In diesem ersten Abschnitt kurzer Länge wird die Baugruppe beim Einschieben geführt und nach beendetem Einschieben gehalten. An den Abschnitt schließt ein verhältnismäßig langer, sich bis kurz vor das Schienenende erstreckender zweiter Abschnitt an, in dem die Nut wesentlich breiter als die Leiterplatte dick ist. Der mittlere breite Nutenabschnitt dient zur Aufnahme der zulässigen Leiterplattendurchbiegung, die z.B. bei Mehrlagenplatten bis zu 2 mm betragen kann. Damit die beispielsweise aus einer oder mehreren Kontaktleisten bestehenden Anschlußelemente der Leiterplatte mit komplementären Steckverbindern an der Rückseite des Baugruppenträgers 1 in sicheren Eingriff gelangen können, folgt dem zweiten Abschnitt noch ein schmalerer, dritter Abschnitt von z.B. ebenfalls 10 mm Länge. Dieser sich somit am Ende der Führungsschiene 2 befindliche rückwärtige Abschnitt hat eine Nutbreite, die etwas kleiner ist als der laterale Fangbereich der aus den zuvor erwähnten Kontaktleisten bestehenden Steckverbindung. Die Nutbreite im rückwärtigen Abschnitt der Führungsschiene 2 sorgt für die Ausrichtung der Baugruppe, bevor es zum Kontakteingriff kommt.

Die vorderen Enden der Führungsschienen oder -matten 2 sind an den vorderen Querträgern 4a und 4b befestigt, z.B. durch Rastverbindungen. Diese Querträger haben Vierkantrohrprofil und können große Lasten bei geringer Durchbiegung aufnehmen. Anstelle eines geschlossenen Rohrprofils können die Querträger, wie Fig. 2 erkennen läßt, auch aus zwei U-Profilen zusammengesetzt sein, die mit den offenen Seiten einander zugewandt auf- oder ineinander gelegt sind. Zweckmäßig sind die beiden U-Profilschienen identisch. Stirnseitig sind die Querträger 4a und 4b wechselweise mit Positioniernasen 12 und Schweißzapfen 13 versehen, wobei erstere das lagerichtige Fügen mit den Seitenwänden 3a bzw. 3b erleichtern und letztere zum Verschweißen mit den Seitenwänden dienen.

Werden alle Teile des Baugruppenträgers 1, also Seitenwände, Querträger und Führungsschienen aus nichtrostendem, ferritischem Stahlblech hergestellt, so bedarf es zum einen keiner weiteren Oberflächenbehandlung und zum anderen haben die Teile gute Abschirmeigenschaften gegen elektromagnetische Störstrahlung. An den Vorderkanten sind die Seitenwände 3a bzw. 3b jeweils mit einer auswärts gerichteten Abkantung 14 versehen, um die Stabilität zu erhöhen. Ferner können in den Seitenwänden freigeschnittene und nach außen gebogene Befestigungswinkel 15 mit entsprechenden Löchern zum Montieren in Gestellen und Schränken vorgesehen werden.

## Patentansprüche

1. Baugruppenträger der Nachrichtentechnik mit Seitenwänden und diese verbindenden vorderen und hinteren Querträgern, an denen Führungsschienen zur Aufnahme einschiebbarer Baugruppen befestigt sind,
**dadurch gekennzeichnet**, daß die beiden hinteren Querträger (5a, 5b) und die beiden Seitenwände (3a, 3b) einstückig U-förmig aus Stahlblech gebogen sind, wobei die Querträger (5a, 5b) jeweils U-förmigen Querschnitt mit einander zugewandten offenen Seiten haben, und daß die vorderen Querträger (4a, 4b) mit den Seitenwänden (3a, 3b) verschweißt sind.

2. Baugruppenträger nach Anspruch 1, dadurch gekennzeichnet, daß die außen liegenden Schenkel (9) der hinteren Querträger (5a, 5b) und vertikale, in der gleichen Ebene liegende Streifen (6) der Seitenwände (3a, 3b) einen umlaufenden rückwärtigen Rahmen bilden.

3. Baugruppenträger nach Anspruch 2, dadurch gekennzeichnet, daß die hinteren Querträger (5a, 5b) mit Positionierschlitzen (10) zum Einstecken der Führungsschienen (2) sowie Noppen (7) und Gewindebohrungen (8) zum Fixieren einer Rückwand (11) aufweisen.

4. Baugruppenträger nach Anspruch 1, dadurch gekennzeichnet, daß die vorderen Querträger (4a, 4b) Vierkanthohlprofil haben und stirnseitig jeweils an den vier Kanten umlaufend wechselweise mit Positioniernasen (12) und Schweißzapfen (13) versehen sind.

5. Baugruppenträger nach Anspruch 4, dadurch gekennzeichnet, daß die vorderen Querträger (4a, 4b) jeweils aus zwei auf Umschlag aufeinander gelegten, U-förmigen Schienen bestehen.

6. Baugruppenträger nach Anspruch 4, dadurch gekennzeichnet, daß die vorderen Querträger (4a, 4b) mit Rastvorrichtungen zum Fixieren der Führungsschienen (2) versehen sind.

7. Baugruppenträger nach Anspruch 1, dadurch gekennzeichnet, daß jede Führungsschiene (2) mehrere Abschnitte mit unterschiedlicher Nutbreite hat, von denen ein vorderer schmaler Abschnitt die Baugruppe haltert, ein mittlerer breiter Abschnitt Durchbiegungen der Baugruppe aufnimmt und ein rückwärtiger Abschnitt die Baugruppe auf den Fangbereich von Steckverbindern des Baugruppenträgers (1) ausrichtet.

8. Baugruppenträger nach Anspruch 1, dadurch gekennzeichnet, daß Seitenwände (3a, 3b), Querträger (4a, 4b, 5a, 5b) und Führungsschienen (2) aus nichtrostendem, ferritischem Stahl bestehen.

## Claims

1. A subrack for communication systems having sidewalls and front and rear horizontal bars which interconnect said sidewalls and to which runners for receiving slide-in modules are attached,
**characterized in** that the two rear horizontal bars (5a, 5b) and the two sidewalls (3a, 3b) are one-piece sheet-steel parts bent into a U shape, with the horizontal bars (5a, 5b) being of U-shaped section with the open sides facing each other, and that the front horizontal bars (4a, 4b) are welded to the sidewalls (3a, 3b).

2. A subrack as claimed in claim 1, characterized in that the outer legs (9) of the rear horizontal bars (5a, 5b) and vertical, coplanar strips (6) of the sidewalls (3a, 3b) form a continuous rear frame.

3. A subrack as claimed in claim 2, characterized in that the rear horizontal bars (5a, 5b) have positioning slots (10) for inserting the runners (2) as well as projections (7) and tapped holes (8) for fixing a rear wall (11) in position.

4. A subrack as claimed in claim 1, characterized in that the front horizontal bars (4a, 4b) are hollow square sections and each have alternate positioning noses (12) and welding lugs (13) at the front end of the four sides.

5. A subrack as claimed in claim 4, characterized in that the front horizontal bars (4a, 4b) each consist of two U-shaped runners laid oppositely one on top of the other.

6. A subrack as claimed in claim 4, characterized in that the front horizontal bars (4a, 4b) are provided with means for fixing the runners (2) in position.

7. A subrack as claimed in claim 1, characterized in that each of the runners (2) has several sections of differing groove widths of which a narrow front section holds the module, a wide center section receives sagging portions of the module, and a rear section aligns the module with connectors of the subrack (1).

8. A subrack as claimed in claim 1, characterized in that sidewalls (3a, 3b), horizontal bars (4a, 4b, 5a, 5b), and runners (2) are made of stainless ferritic steel.

## Revendications

1. Baie support de sous-ensembles de la technique des télécommunications, présentant des parois latérales et des traverses avant et arrière qui les relient et sur lesquelles des rails de guidage sont fixés pour recevoir des sous-ensembles enfichables,
caractérisée par le fait que les deux traverses arrière (5a, 5b), et les deux parois latérales (3a, 3b) sont pliées en tôle d'acier en forme de U d'une seule pièce, chacune des traverses (5a, 5b) ayant une section en forme de U avec des côtés ouverts orientés l'un vers l'autre, et que les traverses avant (4a, 4b) sont soudées aux parois latérales (3a, 3b).

2. Baie support de sous-ensembles selon la revendication 1, caractérisée par le fait que les ailes (9), situées à l'extérieur, des traverses arrière (5a, 5b) et des rabats verticaux (6), situés dans le même plan, des parois latérales (3a, 3b) forment un cadre arrière continu.

3. Baie support de sous-ensembles selon la revendication 2, caractérisée par le fait que les traverses arrière (5a, 5b) présentent des fentes de positionnement (10) pour l'enfichage des rails de guidage (2) ainsi que des bossages (7) et des trous taraudés (8 pour la fixation d'un paroi arrière (11).

4. Baie support de sous-ensembles selon la revendication 1, caractérisée par le fait que les traverses avant (4a, 4b) ont un profil creux tétragonal et, côté frontal, sont chacune munies, en continu sur les quatre bords, alternativement de talons de positionnement (12) et de tenons de soudage (13).

5. Baie support de sous-ensembles selon la revendication 4, caractérisée par le fait que chacune des traverses avant (4a, 4b) est constituée de deux rails en forme de U venant s'envelopper l'un l'autre.

6. Baie support de sous-ensembles selon la revendication 4, caractérisée par le fait que les traverses avant (4a, 4b) sont munies de dispositifs de crantage pour la fixation des rails de guidage (2).

7. Baie support de sous-ensembles selon la revendication 1, caractérisée par le fait que chaque rail de guidage (2) présente plusieurs portions de largeur de rainure différente, dont une première portion, étroite, maintient le sous-ensemble, une portion médiane, plus large, reçoit les parties cintrées du sous-ensemble et une portion arrière redresse le sous-ensemble sur la zone de saisie par les connecteurs de la baie (1) support de sous-ensembles.

8. Baie support de sous-ensembles selon la revendication 1, caractérisée par le fait que parois latérales (3a, 3b), traverses (4a, ab, 5a, 5b) et rails de guidage (2) sont constitués d'acier ferritique inoxydable.
